(19) **Europäisches Patentamt**

**European Patent Office**

**Office européen des brevets**

(11) **EP 0 859 460 B1**

(12) **EUROPEAN PATENT SPECIFICATION**

(45) Date of publication and mention
of the grant of the patent:
**14.06.2000 Bulletin 2000/24**

(51) Int Cl.7: **H03D 7/14**

(21) Application number: **97102309.8**

(22) Date of filing: **13.02.1997**

(54) **Mixer circuit with wide dynamic range**

Mischerschaltung mit weitem Dynamikbereich

Circuit mélangeur à gamme dynamique étendue

(84) Designated Contracting States:
**DE GB**

(43) Date of publication of application:
**19.08.1998 Bulletin 1998/34**

(73) Proprietor: **NEC CORPORATION**
**Tokyo (JP)**

(72) Inventor: **Ando, Yoshiaki**
**Minato-ku, Tokyo (JP)**

(74) Representative:
**Baronetzky, Klaus, Dipl.-Ing. et al**
**Splanemann Reitzner**
**Baronetzky Westendorp**
**Patentanwälte**
**Rumfordstrasse 7**
**80469 München (DE)**

(56) References cited:
**DE-A- 3 304 181**      **US-A- 3 702 968**
**US-A- 4 216 431**

## Description

Background of the Invention

1. Field of the invention

The present invention relates to a mixer circuit, and more particularly to a double balanced-type frequency mixer circuit for performing a process of frequency conversion in a radio-frequency communication equipment.

2. Description of Related Art

As an example of a conventional mixer circuit, there is well known a so-called double balanced-type mixer circuit in which differential circuits are arranged in 2 stages in a vertical direction. Such a mixer circuit is disclosed in, for example, Japanese Laid Open Utility Model disclosure (JP-U-Showa 61-136646). Fig. 1 is a circuit diagram illustrating the structure of the double balanced-type frequency mixer circuit.

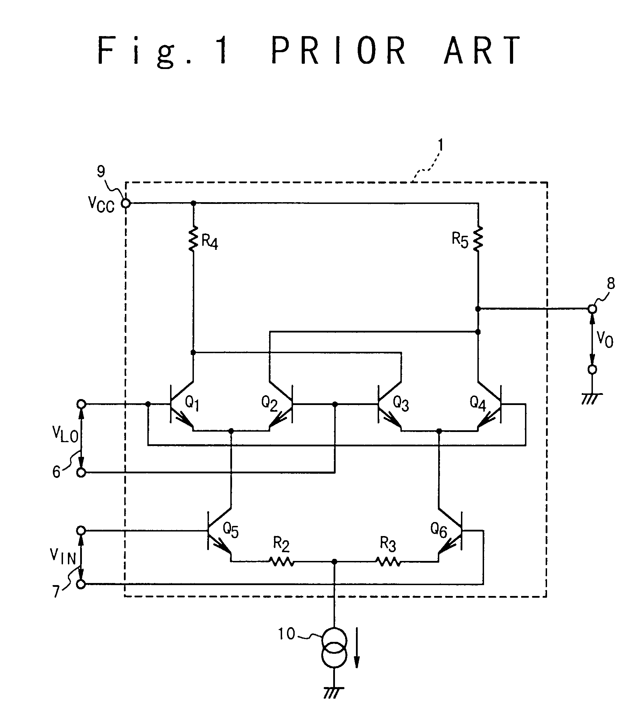

As shown in Fig. 1, the emitters of transistors Q5 and Q6 are respectively connected in common through resistors R2 and R3 and are grounded through a constant current source 10. The bases of the transistors Q5 and Q6 are connected to input terminals 7. The emitters of transistors Q1 and Q2 are connected in common and connected to the collector of the transistor Q5. Also, the emitters of transistors Q3 and Q4 are connected in common and connected to the collector of the transistor Q6. Also, the bases of the transistors Q1 and Q4 are connected in common and the bases of the transistors Q2 and Q3 are connected in common. The bases of the transistors Q1 and Q4 and the bases of the transistors Q2 and Q3 are connected to local signal input terminals 6. The collectors of the transistors Q1 and Q3 are connected in common and connected to a power supply voltage supply terminal 9 through a load resistor R4. The collectors of the transistors Q2 and Q4 are connected in common and connected to the power supply voltage supply terminal 9 through a load resistor R5 and to an output terminal 8.

Assuming that the power supply voltage is Vcc, the saturation voltage between the emitter and the collector of each of the transistors Q1 to Q6 is Vsat, the potential difference across both ends of the constant current source 10 is VC, and a voltage drop by the resistor R2 is VR2, the maximum amplitude Vomax which can be outputted from the output terminal 8 is

$$Vomax = (VCC - VC - 2Vsat - VR2)/2 \qquad (1)$$

In the above-mentioned conventional mixer circuit, because the maximum amplitude Vomax is limited by three parameters of VC, Vsat, and VR2 when the power supply voltage VCC is constant. Therefore, it is not possible to widen the output dynamic range. For this reason, the dynamic range of a radio-frequency communication equipment is limited by the mixer circuit. This is one factor that the characteristics of the radio-frequency communication equipment are degraded.

Another example of a mixer circuit is known from DE-A-3 304 181. With such a mixer, it is difficult to obtain a wide output dynamic range. The dynamic range is limited by the mixer circuit which degrades the characteristic of the overall RF communication equipment.

Summary of the Invention

Therefore, an object of the present invention is to provide a mixer circuit in which an output dynamic range can be made wide such that the characteristics of a radio communication equipment can be improved.

In order to achieve an aspect of the present invention, a mixer circuit includes a double balanced circuit for inputting a local signal and a signal and outputting first and second current signals having phases inverse to each other, first and second current mirror sections for inputting the first and second current signals from the double balanced circuit, and outputting third and fourth current signals, respectively, a third current mirror section for inputting the third current signal from the first current mirror section and outputting a fifth current signal, and a converting section for performing current - voltage conversion based on the fourth current signal from the second current mirror section and the fifth current signal from the third current mirror section to supply an output signal.

The converting section includes an impedance element connected to outputs of the second and third current mirror section at one end, and a constant voltage source connected between the other end of the impedance element and the ground. The voltage of the constant voltage source is set to 1/2 of an operation voltage of the mixer circuit. The impedance element may be a resistive element or a resonance circuit such as an RLC parallel resonance circuit.

In order to achieve another aspect of the present invention, a method of widening a dynamic range in a mixer circuit, includes the steps of: generating first and second current signals having phases inverse to each other by a double balanced circuit from a local signal and a signal and outputting; generating third and fourth current signals by first and second current mirror circuits from the first and second current signals, respectively; generating a fifth current signal by a third current mirror circuit from the third current signal; and performing current - voltage conversion based on the fourth current signal from the second current mirror circuit and the fifth current signal from the third current mirror circuit to generate an output signal. Here, the performing step may include limiting a band width of the output signal.

Brief Description of the Drawings

Fig. 1 is a circuit diagram illustrating a conventional mixer circuit;

Fig. 2 is a circuit diagram illustrating the structure of the mixer circuit according to the first embodiment of the present invention; and

Fig. 3 is a circuit diagram illustrating the structure of the mixer circuit according to an embodiment of the present invention.

Description of the Preferred Embodiments

The mixer circuit of the present invention will be described below in detail with reference to the accompanying drawings.

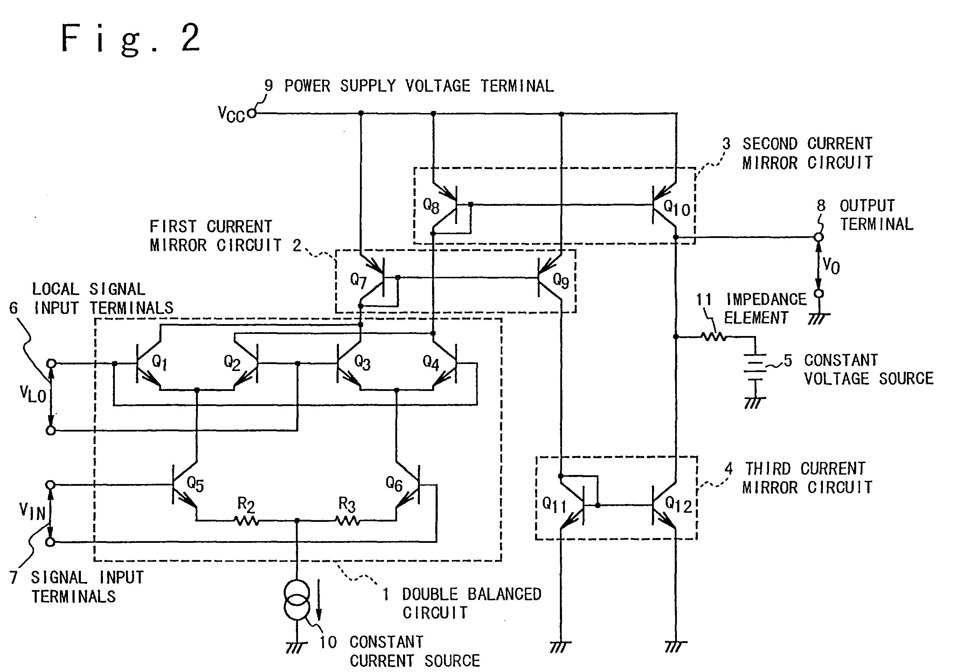

Fig. 2 is a circuit diagram illustrating the structure of the mixer circuit of the first embodiment of the present invention. As shown in Fig. 2, in the present embodiment, the double balanced circuit 1 is composed of transistors Q1 to Q6 and resistors R2 and R3. The emitters of transistors Q5 and Q6 are respectively connected in common through resistors R2 and R3 and are grounded through a constant current source 10. The bases of the transistors Q5 and Q6 are connected to signal input terminals 7. The emitters of transistors Q1 and Q2 are connected in common and connected to the collector of the transistor Q5. Also, the emitters of transistors Q3 and Q4 are connected in common and connected to the collector of the transistor Q6. Also, the bases of the transistors Q1 and Q4 are connected in common and the bases of the transistors Q2 and Q3 are connected in common. The bases of the transistors Q1 and Q4 and the bases of the transistors Q2 and Q3 are connected to local signal input terminals 6. The collectors of the transistors Q1 and Q3 are connected in common and the collectors of the transistors Q2 and Q4 are connected in common.

The first current mirror circuit 2 is composed of transistors Q7 and Q9. The emitter of the transistor Q7 is connected to the base and the collectors of the transistors Q1 and Q3. The base of the transistor Q7 is connected to the base of the transistor Q9. The collectors of the transistors Q7 and Q9 are connected to a power supply voltage supply terminal 9.

The second current mirror circuit 3 is composed of transistors Q8 and Q10. The emitter of the transistor Q8 is connected to the base and the collectors of the transistors Q2 and Q4. The base of the transistor Q8 is connected to the base of the transistor Q10. The collectors of the transistors Q8 and Q10 are connected to a power supply voltage supply terminal 9.

The third current mirror circuit is composed of transistors Q11 and Q12. The collector of the transistor Q11 is connected to the base and to the emitter of the transistor Q9. The base of the transistor Q11 is connected to the base of the transistor Q12. The collector of the transistor Q12 is connected to the emitter of the transistor Q10. The emitters of the transistors Q11 and Q12 are grounded.

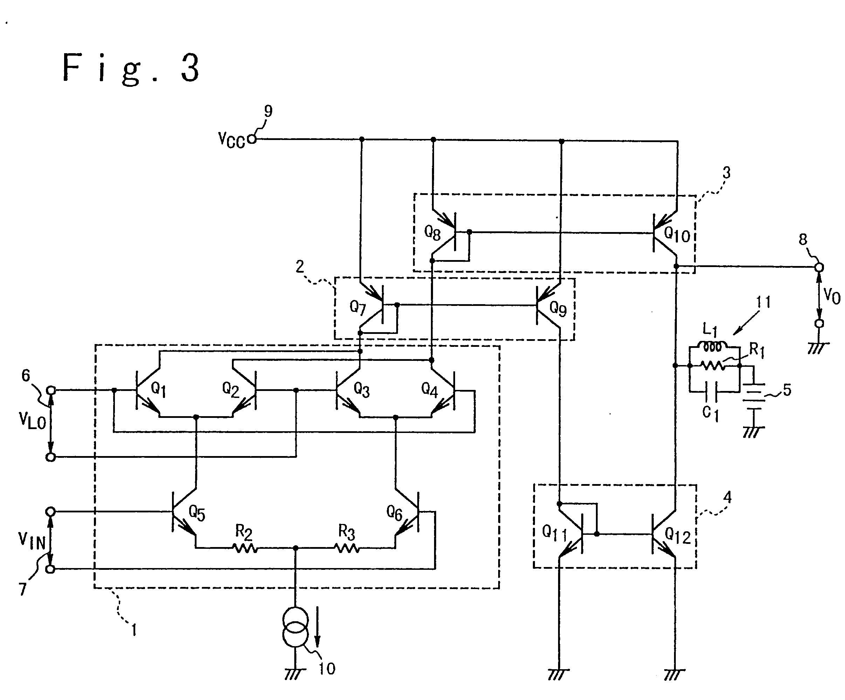

The impedance element 11 is composed as may be taken from Fig. 3. The one end of the impedance element 11 is connected to the emitter of the transistor Q10. The constant voltage source 5 is connected between the other end of the resistor R1 11 and the ground to supply the voltage of Vcc/2.

Next, the operation of the mixer circuit in the first embodiment will be described in detail. When the input signal is inputted from the input terminals 7 to the double balanced circuit 1 and the local signal is inputted from the local signal input terminals 6 to the double balanced circuit 1. These signals are mixed. Subsequently, down-conversion or up-conversion is performed, and current outputs are provided. When it is assumed that current ratio of the first, second and third current mirror circuits are 1 : 1 : 1, a difference of currents outputted from the double balanced circuit 1 and having the phases inverse to each other is outputted from a push-pull circuit composed of transistors Q10 and Q12. The difference current is subjected to current - voltage conversion by the resistor R1. The converted voltage is outputted as the mixer output from the output terminal 8.

Assuming that the power supply voltage is Vcc, the saturation voltage between the emitter and the collector of each of the transistors Q10 and Q12 is Vsatl, the maximum amplitude Vomaxl which can be outputted from the output terminal 8 in this embodiment is

$$Vomax1 = (Vcc - 2Vsat1)/2 \qquad (2)$$

Fig. 3 is a circuit diagram illustrating the mixer circuit according to the second embodiment of the present invention. The same components as in Fig. 2 are indicated by the same reference numerals or symbols. As shown in Fig. 3, the mixer circuit in the second embodiment includes an RLC parallel resonance circuit composed of an inductor L1, a resistor R1 and a capacity C1 instead of the impedance element 11 in Fig. 2.

In this embodiment, band limitation is performed to the output signal by the RLC parallel resonance circuit. Therefore, the embodiment has the effects of noise suppression and spurious output suppression. In addition, the maximum amplitude of the output is the same as the equation (2).

In the embodiments, the voltage of the constant voltage source is Vcc/2 and the impedance element is composed of the resistor or the RLC parallel resonance circuit. However, the voltage of the constant voltage source may have a different value and it is not necessary to use the resistor or the RLC parallel resonance circuit as the impedance element. When the voltage of the constant voltage source is set to Vcc/2, the voltage Vcc of the circuit power supply can be most effectively used.

As a specific example, when Vcc = 3 V, Vsat = Vsatl = 0.2 V, Vc = 4 V, VR2 = 0.4 V, the maximum output amplitude Vomax in the conventional example and the maximum output amplitude Vomax1 in the present invention are: from the equation (1),

$$Vomax = 0.9 \, V$$

from the equation (2)

$$Vomax1 = 1.3 \, V$$

Therefore, it could be understood that the output dynamic range in the present invention is made wider about 1.5 times than that in the conventional example.

As described above, according to the present invention, the mixer circuit is composed of the double balanced circuit, the current mirror circuits and the constant voltage source. The current difference of the mixing outputs from the double balanced circuit having the phases opposite to each other is outputted from an output circuit having a push-pull structure. The output current of the output circuit is subjected to the current - voltage conversion by the resistor R1 using the DC voltage of the constant voltage source as reference. Therefore, the output dynamic range can be made wide without depending on the emitter - collector saturation voltage Vsat of each of the transistors in the double balanced circuit, the potential difference Vc across the both ends of the constant current source and the voltage drop VR2 by the resistor R2.

**Claims**

1. A mixer circuit comprising:

   a double balanced circuit (1) for inputting a local signal and a signal and outputting first and second current signals having phases inverse to each other;

   first and second current mirror means (2, 3) for inputting said first and second current signals from said double balanced circuit, and outputting third and fourth current signals, respectively;

   third current mirror means (4) for inputting said third current signal from said first current mirror means (2) and outputting a fifth current signal; and

converting means (11, 5) for performing current - voltage conversion based on said fourth current signal from said second current mirror means (3) and said fifth current signal from said third current mirror means (4) to supply an output signal,

   said converting means including an impedance element (11) connected directly to outputs of said second and third current mirror means at one end;

   a constant voltage source (5) connected between the other end of said impedance element and the ground, and

   characterized in that said a voltage of said constant voltage source is set to 1/2 of an operation voltage of said mixer circuit, and

   that said impedance element is a resonance circuit.

2. A mixer circuit according to claim 1, wherein said resonance circuit is an RLC parallel resonance circuit.

3. A mixer circuit according to claim 1, wherein a transistor of said second current mirror means and a transistor of said third current mirror means are connected to form a push-pull circuit.

4. A method of widening a dynamic range in a mixer circuit, comprising the steps of:

   generating first and second current signals having phases inverse to each other by a double balanced circuit from a local signal and a signal and outputting;

   generating third and fourth current signals by first and second current mirror circuits from said first and second current signals, respectively;

   generating a fifth current signal by a third current mirror circuit from said third current signal; characterized by

   performing current-voltage conversion based on said fourth current signal from said second current mirror circuit and said fifth current signal from said third current mirror circuit, using a constant voltage source for setting one end of a resonance circuit to 1/2 of an operation voltage of said mixer circuit with the other end of said resonance circuit connected directly to outputs of said second and third current mirror circuits, to generate an output signal.

**5.** A method according to claim 4, wherein said performing step includes limiting a band width of said output signal.

**Patentansprüche**

**1.** Mischerschaltkreis, welcher folgendes aufweist:

einen phasengleichen Doppelschaltkreis (1) für die Eingabe eines lokalen Signals und eines weiteren Signals, und für die Ausgabe eines ersten und eines zweiten Stromsignals, wobei das erste und das zweite Stromsignal zueinander entgegengesetzte Phasen aufweisen;

eine erste und zweite Stromspiegelungsvorrichtung (2, 3) für die Eingabe des vom phasengleichen Doppelschaltkreis ausgegebenen ersten bzw. zweiten Signals, und für die Ausgabe des dritten bzw. vierten Stromsignals;

eine dritte Stromspiegelungsvorrichtung (4) für die Eingabe des von der ersten Stromspiegelungsvorrichtung (2) ausgegebenen dritten Stromsignals, und für die Ausgabe eines fünften Stromsignals; und

Umwandlungsvorrichtungen (11, 5) für die Durchführung einer Strom-Spannungs-Umwandlung basierend auf dem von der zweiten Stromspiegelungsvorrichtung (3) ausgegebenen vierten Stromsignals und dem von der dritten Stromspiegelungsvorrichtung (4) ausgegebenen fünften Stromsignals zur Lieferung eines Ausgangssignals, wobei

die Umwandlungsvorrichtung ein Impedanzbauelement (11) aufweist, welches direkt mit Ausgängen der zweiten und dritten Stromspiegelungsvorrichtung an einem Ende verbunden ist; und

eine Konstantspannungsquelle (5) zwischen dem anderen Ende des Impedanzbauelements und der Masse angeschlossen ist;

dadurch gekennzeichnet, daß

die Spannung der Konstantspannungsquelle so eingestellt ist, daß diese die Hälfte der Betriebsspannung des Mischerschaltkreises beträgt, und daß

das Impedanzbauelement ein Resonanzschaltkreis ist.

**2.** Mischerschaltkreis nach Anspruch 1, dadurch gekennzeichnet, daß der Resonanzschaltkreis ein paralleler RLC-Resonanzschaltkreis ist (RLC = Widerstand, Induktivität, Kapazität).

**3.** Mischerschaltkreis nach Anspruch 1, dadurch gekennzeichnet, daß ein Transistor der zweiten Stromspiegelungsvorrichtung und ein Transistor der dritten Stromspiegelungsvorrichtung zur Bildung eines Gegentakt-Schaltkreises miteinander verbunden sind.

**4.** Verfahren zur Ausdehnung eines Dynamikbereichs in einem Mischerschaltkreis, wobei das Verfahren folgende Schritte aufweist:

die Erzeugung eines ersten und eines zweiten Stromsignals aus einem lokalen Signal und einem weiteren Signal mit Hilfe eines phasengleichen Doppelschaltkreises, wobei das erste und das zweite Stromsignal zueinander entgegengesetzte Phasen aufweisen, und die Ausgabe der Signale;

die Erzeugung eines dritten und vierten Stromsignals aus dem ersten bzw. zweiten Stromsignal mit Hilfe eines ersten bzw. zweiten Stromspiegelungsschaltkreises;

die Erzeugung eines fünften Stromsignals aus einem dritten Stromsignal mit Hilfe einer dritten Stromspiegelungsvorrichtung; dadurch gekennzeichnet, daß

eine Strom-Spannungs-Umwandlung basierend auf dem vom zweiten Stromspiegelungsschaltkreis ausgegebenen vierten Stromsignal und dem vom dritten Stromspiegelungsschaltkreis ausgegebenen fünften Stromsignal durchgeführt wird, wobei eine Konstantspannungsquelle für das Einstellen eines Endes des Resonanzschaltkreises auf die Hälfte einer Betriebsspannung des Mischerschaltkreises verwendet wird, während das andere Ende des Resonanzschaltkreises direkt mit den Ausgängen des zweiten bzw. dritten Stromspiegelungsschaltkreises verbunden ist.

**5.** Verfahren nach Anspruch 4, dadurch gekennzeichnet, daß dieser Durchführungsschritt die Einschränkung einer Bandbreite des Ausgangssignals umfaßt.

**Revendications**

**1.** Un circuit mélangeur qui comporte:

un circuit double équilibré (1) pour entrer un signal local et un signal et pour sortir un premier et un deuxième signal de courant ayant des phases inversées l'un par rapport à l'autre;

premier et deuxième moyen de miroitement de courant (2, 3) pour entrer ledit premier et ledit deuxième signal de courant dudit circuit double équilibré, et sortir un troisième et un quatrième signal de courant, respectivement:

troisième moyen de miroitement de courant (4) pour entrer ledit troisième signal de courant dudit premier moyen de miroitement de courant (2) et sortir un cinquième signal de courant et:

moyen de conversion (11, 5) pour effectuer la conversion courant - voltage basée sur ledit quatrième signal de courant dudit deuxième moyen de miroitement de courant (3) et ledit cinquième signal de courant dudit troisième moyen de miroitement de courant (4) pour fournir un signal de sortie, ledit moyen de conversion incluant un élément d'impédance (11) relié directement à des sorties dudit deuxième et dudit troisième moyen de miroitement de courant à une extrémité et une source de voltage constante (5) reliée entre l'autre extrémité dudit élément d'impédance et la terre,

caractérisé en ce que ledit voltage de ladite source de voltage constante soit réglé sur la moitié d'un voltage d'opération dudit circuit mélangeur, et que ledit élément d'impédance soit un circuit de résonance.

2. Un circuit mélangeur selon la revendication 1, où ledit circuit de résonance est un circuit de résonance RLC parallèle.

3. Un circuit mélangeur selon la revendication 1, où un transistor dudit deuxième moyen de miroitement de courant et un transistor dudit troisième moyen de miroitement de courant soient reliés pour former un circuit push-pull.

4. Une méthode pour élargir une gamme dynamique dans un circuit mélangeur, comportant des pas suivants:

produire un premier et un deuxième signal de courant ayant des phases inversées l'un par rapport à l'autre par un circuit double équilibré depuis un signal local et un signal et sortir;

produire un troisième et un quatrième signal de courant par un premier et un deuxième circuit de miroitement de courant dudit premier et deuxième signal de courant, respectivement;

produire un cinquième signal de courant par un troisième circuit de miroitement de courant dudit troisième signal de courant; caractérisé par

l'exécution de la conversion courant - voltage basée sur ledit quatrième signal de courant du conversion dudit deuxième circuit de miroitement de courant et dudit cinquième signal de courant dudit troisième circuit de miroitement de courant en utilisant une source de voltage constante pour régler une extrémité d'un circuit de résonance sur la moitié d'un voltage d'opération dudit circuit mélangeur, l'autre extrémité dudit circuit de résonance étant reliée directement aux sorties dudit deuxième et dudit troisième circuit de miroitement de courant, pour produire un signal de sortie.

5. Une méthode selon la revendication 4, où ledit pas d'exécution comprend la limitation d'une bande passante dudit signal de sortie.

# Fig. 1 PRIOR ART

# Fig. 2

3 SECOND CURRENT MIRROR CIRCUIT

8 OUTPUT TERMINAL

V0

5 CONSTANT VOLTAGE SOURCE

11 IMPEDANCE ELEMENT

4 THIRD CURRENT MIRROR CIRCUIT

Q10  Q12  Q11  Q9  Q8  Q7

9 POWER SUPPLY VOLTAGE TERMINAL

VCC

FIRST CURRENT MIRROR CIRCUIT 2

Q4  Q3  Q2  Q1

Q6  Q5  R3  R2

1 DOUBLE BALANCED CIRCUIT

10 CONSTANT CURRENT SOURCE

6 LOCAL SIGNAL INPUT TERMINALS

VLO

VIN

7 SIGNAL INPUT TERMINALS

8

Fig. 3

$V_{CC}$ 9

$V_0$ 8

11 $L_1$ $R_1$ $C_1$ 5

$Q_{10}$ 3 $Q_{12}$ 4 $Q_{11}$

$Q_9$ $Q_8$ $Q_7$ 2

$Q_4$ $Q_3$ $Q_2$ $Q_1$ $Q_6$ $Q_5$ $R_3$ $R_2$ 10 1

6 $V_{L0}$ $V_{IN}$ 7